# EUROPÄISCHE PATENTSCHRIFT

(11) **EP 1 642 379 B1**
(45) Veröffentlichungstag und Bekanntmachung des Hinweises auf die Patenterteilung: **17.09.2008**
(21) Anmeldenummer: 04766121.0
(22) Anmeldetag: 02.07.2004
(51) Int. Cl.: H02K 11/02

(54) **SCHALTUNGSANORDNUNG ZUR EMV-ENTSTÖRTUNG EINES GLEICHSTROMMOTORS SOWIE SCHALTMODUL**
CIRCUIT ARRANGEMENT FOR EMV-SUPPRESSION OF A DIRECT CURRENT MOTOR, AND SWITCHING MODULE
CIRCUIT DE DEPARASITAGE ANTI-INTERFERENCES ELECTROMAGNETIQUES D'UN MOTEUR A COURANT CONTINU ET MODULE DE COMMUTATION

(30) Priorität: 08.07.2003 DE 10330806
(43) Veröffentlichungstag der Anmeldung: 05.04.2006
(73) Patentinhaber: Continental Automotive GmbH, 30165 Hannover (DE)
(72) Erfinder: GOTTMANN, Wolfgang, 93491 Stamsried (DE); KIRCHBERGER, Michael, 93073 Neutraubling (DE)
(86) Internationale Anmeldenummer: PCT/EP2004/051344
(87) Internationale Veröffentlichungsnummer: WO 2005/006519

(56) Entgegenhaltungen:
- FR-A- 2 742 006
- US-A- 5 997 267
- US-B1- 6 232 684

## Beschreibung

Die Erfindung geht aus von einer Schaltungsanordnung zur EMV-Entstörung eines Gleichstrommotors, wobei in die Versorgungsleitung des Gleichstrommotors ein Dämpfungsglied geschaltet ist, beziehungsweise von einem Schaltmodul mit einem Dämpfungsglied nach der Gattung der nebengeordneten Ansprüche 1 und 10.

Es ist schon bekannt, beispielsweise bei einem Gleichstrommotor (DC-Motor), dessen Läufer über Bürsten mit Strom versorgt wird, das am Kollektor entstehende Bürstenfeuer zu unterdrücken oder mindestens so zu dämpfen, dass die entstehende Störstrahlung unschädlich wird. Diese Entstörung zur Erreichung einer elektromagnetischen Verträglichkeit - im folgenden kurz als EMV-Entstörung bezeichnet - wird mittels eines Dämpfungsgliedes erreicht, das in der Regel aus mehreren elektronischen Bauteilen aufgebaut ist. Beispielsweise werden in die beiden Versorgungsleitungen zwei Y-Kondensatoren gegen das Motorgehäuse und zwei Längsdrosseln vorgeschaltet, um den Hochfrequenz-Widerstand zu erhöhen. Mit dieser Maßnahme kann zwar das Bürstenfeuer gedämpft werden, sie ist jedoch durch die Verwendung von vier Bauteilen relativ aufwendig und erfordert einen nicht zu vernachlässigenden zusätzlichen Einbauraum, der bei vielen Anwendungen nicht vorhanden ist oder eine unerwünschte Einschränkung in der Konstruktion bedeutet.

Des Weiteren ist schon bekannt, insbesondere hochfrequente Störsignale, wie sie beispielsweise bei den Kabelverbindungen zwischen einem Computer und einem Monitor, Drucker, Datenleitungen oder dergleichen auftreten können, zur Entkopplung von leitungsgebundenen hochfrequenten Signalen EMV-Ferrite einzusetzen. Derartige Ferrite werden beispielsweise von der Firma Würth Elektronik oder Vacuumschmelze vertrieben und sind in verschiedenen Bauformen erhältlich. Diese Dämpfungsglieder sind allerdings nur für den Einsatz in Computer- und Datenleitungen vorgesehen und können nur einen auf wenige Ampere begrenzten Gleichstrom übertragen.

Aus der US 5 997 267 A geht eine Schaltungsanordnung zur EMV-Entstörung eines Gleichstrommotors hervor, wobei in die Versorgungsleitung des Gleichstrommotors ein Dämpfungsglied geschaltet ist, das insbesondere für hochfrequente Signale einen hohen Widerstand bildet. Das Dämpfungsglied weist ein Ferritmaterial auf und ist auf einer gedruckten Schaltung angeordnet, die zur Ansteuerung des Gleichstrommotors dient.

Die US 6 232 684 B1 beschreibt ein Bedienelement für eine Heckklappe eines Autos mit einem Gehäuse, einem Verriegelungsmechanismus in der Heckklappe, elektrischen Versorgungsleitungen, einem elektrischen Antrieb zur Verriegelung bzw. Entriegelung der Heckklappe und einem elektrischen Filter zur EMV-Entstörung.

Aus der US 6 229 226 B1 geht ein Bedienelement zur Positionierung eines Fahrzeugspiegels hervor, das einen Motor mit einem Gehäuse und mindestens einer elektrischen Versorgungsleitung aufweist. Zudem ist ein EMV-Entstörgerät vorgesehen, das extern am Gehäuse befestigt ist.

Der Erfindung liegt die Aufgabe zu Grunde, eine Schaltungsanordnung und ein Schaltmodul mit einem vereinfachten und kostengünstigeren Dämpfungsglied zu bilden. Diese Aufgabe wird mit den Merkmalen der nebengeordneten Ansprüche 1 bzw. 11 gelöst.

Entgegen dem bekannten Stand der Technik wird bei der erfindungsgemäßen Schaltungsanordnung und dem Schaltmodul vorgeschlagen, als Dämpfungsglied ein Ferritmaterial zu verwenden. Ein derartiges Bauteil ist wesentlich preiswerter erhältlich, als die vier Bauteile, die üblicherweise zur EMV-Entstörung verwendet werden. Hinzu kommt, dass sein Einbau leichter und schneller durchführbar ist, so dass die Herstellkosten für den DC-Motor günstiger sind. Als besonders vorteilhaft wird dabei angesehen, dass das Ferritmaterial des Dämpfungsgliedes auf Grund seiner konstruktiven und physikalischen Eigenschaften wesentlich breitbandiger wirkt als ein herkömmliches Dämpfungsglied, so dass insbesondere auch hohe Stromspitzen mit hohen Frequenzen besser gedämpft werden können.

Durch die in den abhängigen Ansprüchen aufgeführten Maßnahmen sind vorteilhafte Weiterbildungen und Verbesserungen der in den nebengeordneten Ansprüchen 1 und 11 angegebenen Schaltungsanordnung beziehungsweise Schaltmoduls gegeben. Als besonders vorteilhaft wird angesehen, dass das Dämpfungsglied einen Common Mode Ferrit aufweist. Dieses Material ist besonders für die Dämpfung hochfrequenter Störsignale ausgebildet, die durch das Bürstenfeuer des DC-Motors entstehen.

Eine optimale EMV-Entstörung wird erreicht, wenn das Dämpfungsglied möglichst nahe am DC-Motor und damit an der Störquelle angeordnet wird. Dann werden die entstehenden Störsignale direkt gedämpft, ohne dass sie sich in benachbarte Leitungen oder Schaltungsteile einkoppeln können.

Eine besonders vorteilhafte Lösung wird auch darin gesehen, das Dämpfungsglied direkt auf einer gedruckten Schaltung anzuordnen, die zur Ansteuerung des DC-Motors dient. Das Dämpfungsglied kann dabei zusammen mit anderen elektronischen Bauelementen, die beispielsweise zur Steuerung des DC-Motors benötigt werden, vorgefertigt werden.

Eine weitere Miniaturisierung kann erzielt werden, wenn das Dämpfungsglied als SMD-Schaltung ausgebildet ist, mit der man eine besonders kleine Bauausführung erhält.

Vorteilhaft erscheint auch die Lösung, die gedruckte Schaltung derart auszubilden, dass auch eine nachträgliche Bestückung mit dem Dämpfungsglied möglich wird. Da nicht bei allen Motortypen oder Anwendungen eine EMV-Enstörung erforderlich ist, kann nach Bedarf das Dämpfungsglied auch nachträglich eingebaut werden. Dabei ist besonders günstig, dass dennoch eine einheitliche gedruckte Schaltung verwendet werden kann.

Das Dämpfungsglied ist besonders dafür ausgebildet, die am Kommutator des DC-Motors entstehenden Störsignale des Bürstenfeuers zu unterdrücken beziehungsweise zu dämpfen. Eine Einkoppelung in benachbarte Leitungen oder eine Funktionsstörung von benachbarten Schaltungsteilen kann damit wirksam unterdrückt werden.

Eine besonders vorteilhafte Anwendung der erfindungsgemäßen Schaltungsanordnung betrifft DC-Motoren, die zum Antrieb einer Einrichtung oder eines Hilfsaggregates in einem Kraftfahrzeug benötigt werden. Diese sind insbesondere solche DC-Motoren, die beispielsweise für eine Getriebesteuerung, einen Scheibenwischer, einen Fensterheber, eine Sitzverstellung oder dergleichen benötigt werden.

Ein Ausführungsbeispiel der Erfindung ist in den Zeichnungen dargestellt und wird in der nachfolgenden-Beschreibung näher erläutert. Es zeigen:
- Figur 1: in schematischer Darstellung einen Stromlaufplan eines DC-Motors mit einem herkömmlichen Dämpfungsglied,
- Figur 2: in schematischer Darstellung einen Stromlaufplan eines DC-Motors mit einem erfindungsgemäßen Dämpfungsglied,
- Figur 3: eine erfindungsgemäße Ausführungsform des Dämpfungsgliedes,
- Figur 4: ein erstes Diagramm mit zwei Störspannungskurven und
- Figur 5: ein zweites Diagramm mit drei Störspannungskurven.

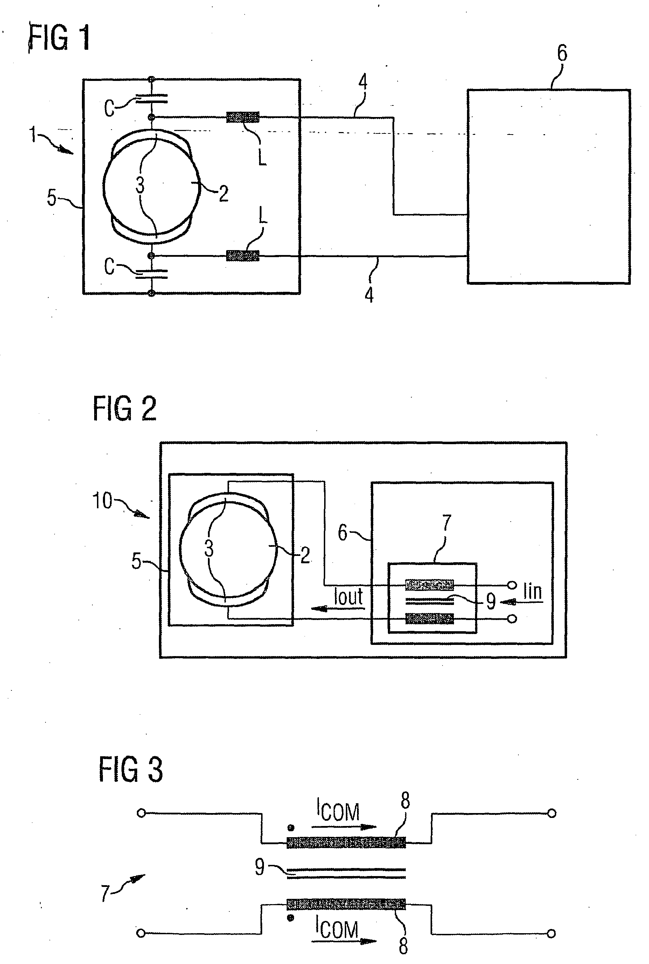

Zum besseren Verständnis der Erfindung wird zunächst an Hand von Figur 1 erläutert, wie bisher bei einem DC-Motor (Gleichstrommotor) die durch das Bürstenfeuer entstehenden Störsignale unterdrückt beziehungsweise gedämpft wurden. Die schematische Darstellung von Figur 1 zeigt einen DC-Motor 1, bei dem in einem Gehäuse 5 ein Läufer 2 angeordnet ist, der mehrere einzeln versorgte Stromwicklungen aufweist und in einem statischen Magnetfeld drehbar ausgebildet ist. Die Stromversorgung des Läufers 2 erfolgt über einen Kommutator, der mittels zwei gegenüberliegend angeordneter Bürsten 3 die Stromwicklungen des Läufers 2 mit einem konstanten oder gepulsten Gleichstrom versorgt. Jede einzelne Stromwicklung des Läufers 2 ist mit zwei Kontaktflächen des Kommutators paarweise verbunden, über die die Bürsten 3 gleiten. Beim Übergleiten der Bürsten 3 zu benachbarten Kontaktflächen entsteht das unerwünschte Bürstenfeuer, das insbesondere im hochfrequenten Bereich Störsignale aussendet, die beispielsweise auf benachbarte Stromleitungen übertragen werden und elektronische Schaltungsteile empfindlich stören können. Diese als EMV-Störung bezeichnete Störstrahlung wird üblicherweise mit einem L/C-Glied gedämpft, das in der Regel aus zwei Kondensatoren C und zwei Entstördrosseln L aufgebaut ist. Wie aus Figur 1 ersichtlich ist, sind die beiden Kondensatoren C, zum Beispiel jeweils 10nF, in einer Y-Schaltung zwischen jeweils einer Leitung 4 und dem Gehäuse 5 möglichst in der Nähe der Bürsten 3 geschaltet. In die Leitungen 4 ist jeweils eine Entstördrossel L, mit beispielsweise 7µH, geschaltet. Dieses L/C-Glied ist möglichst in das Gehäuse 5 einzubauen, da eine Entstörung nahe an der Störquelle die beste Wirkung zeigt.

Für Gleichstrom ist dieses L/C-Glied niederohmig, während es für steil ansteigende und hochfrequente Signale relativ hochohmig wirkt, wie später noch näher erläutert wird. Zur Drehzahl- und Drehmomentsteuerung ist der DC-Motor 1 über die Leitungen 4 mit einer Steuerschaltung verbunden, die häufig auf einer gedruckten Schaltung 6 (PCB-Platine, printed circuit board) aufgebaut ist. Falls die Raumverhältnisse es zulassen, kann die PCB-Platine 6 am oder im Gehäuse 5 angeordnet sein.

Figur 2 zeigt in schematischer Darstellung ein Ausführungsbeispiel der Erfindung. An Stelle des L/C-Gliedes ist jetzt dem zuvor beschriebenen DC-Motor 1 ein Dämpfungsglied 7 vorgeschaltet, das mit einem Ferrit, insbesondere einem Common Mode Ferrit 9 (auch als CM-Choke, Common Mode Choke bezeichnet) ausgebildet ist. Derartige Ferrite sind in der Regel aus mehreren Schichten oder alternativ aus gesintertem Material aufgebaut, um eine möglichst hohe Impedanz zu erzielen. Dazu werden die beiden Leitungen 4 so um den Common Mode Ferrit 9 gewickelt, dass sich ihre Magnetfelder gegenseitig kompensieren. Common Mode Ferrite werden gemäß dem bekannten Stand der Technik nur zur Entkopplung von leitungsgebundenen Störungen im hochfrequenten Bereich empfohlen. Sie sind für verschiedene Anwendungsfälle als einbaufertiges Bauelement beispielsweise auch als SMD-Bauelement handelsüblich, um die Montage auf einer gedruckten Schaltung zu erleichtern. Diese Bauelemente werden typischerweise für Meßsignalaufnehmer, Monitorleitungen, Drucker- und Mauskabel, Datenübertragungsleitungen und ähnliches verwendet. Die Ferrite sind als Blockkerne, Flachbandkabelferrite, Ferrithülsen, Ferritringe, Ferritperlen und Ferritbrücken erhältlich.

Bei dem erfindungsgemäßen Ausführungsbeispiel wird dagegen gemäß Figur 2 vorgeschlagen, einen derartigen Common Mode Ferrit 9 so zu modifizieren, dass das Dämpfungsglied 7 zur Entstörung des DC-Motors 7, insbesondere zur Dämpfung seines Bürstenfeuers verwendet werden kann. Dazu wird eine Schaltungsanordnung vorgeschlagen, bei der das Dämpfungsglied 7 auf eine entsprechend vorbereitete PCB-Platine 6 nahe am oder falls möglich im Gehäuse 5 des DC-Motors 1, also in der Nähe der Bürsten 3 eingebaut werden kann.

Eine bevorzugte Ausführungsform der Erfindung wird auch darin gesehen, das Dämpfungsglied 7 beispielsweise als SMD-Bauteil (surface mounted device) auszuführen und nur bei Bedarf auf der PCB-Platine 6 zu montieren.

Vorzugweise ist die PCB-Platine 6 ist so ausgeführt, dass sie zusammen mit dem Gehäuse 5 des DC-Motors 1 als kompaktes Schaltmodul 10 in einem gemeinsamen Gehäuse verbaut werden kann. Die PCB-Platine 6 enthält zusätzlich eine Steuerschaltung, die beispielsweise mit einer PWM- Schaltung (Pulsweitenmodulation) zur Drehzahl-, Drehmoment- und/oder Wegsteuerung des DC-Motors 1 ausgebildet ist. Derartige Schaltmodule 10 sind dann beispielsweise in einem Kraftfahrzeug zur Steuerung verschiedener Einrichtungen und Hilfsaggregate wie Scheibenwischer, Fensterheber, Sitzverstellung und/oder zur Getriebesteuerung verwendbar. Insbesondere für den letzten Fall muss das Dämpfungsglied 7 für sehr hohe Spitzenströme, zum Beispiel bis 40A ausgelegt sein. Bei handelsüblichen Common Mode Ferriten 9 betragen die Spitzenströme in der Regel nur wenige Ampere, so dass eine entsprechende Modifikation erforderlich ist, um auch bei sehr großen Strömen die gewünschten Dämpfungsmaßnahmen erzielen zu können.

Vorteilhaft ist weiterhin, dass das Dämpfungsglied 7 mit dem Common Mode Ferrit 9 wesentlich kleiner ausgeführt werden kann, als dies bei dem üblichen L/C-Glied der Fall ist. Dadurch ist der Raumbedarf geringer, so dass auch das Gehäuse 5 des DC-Motors 1 entsprechend kleiner und kostengünstiger ausgeführt werden kann. Hinzu kommt, dass die Dämpfung wirkungsvoller und breitbandiger ausgelegt werden kann, wie später noch an Hand von Vergleichsdiagrammen gezeigt wird.

Figur 3 zeigt einen Stromlaufplan für das Dämpfungsglied 7, das als Bauteil mit wenigstens zwei Eingangs- und zwei Ausgangsklemmen ausgebildet ist. Es weist einen Common Mode Ferrit 9 auf, um den die beiden Stromleitungen so gewickelt sind, dass sich die Störpegel der beiden Ströme I_{COM} gegenseitig kompensieren. Für steile Stromflanken und hochfrequente Ströme beziehungsweise Spannungen ist dieses Dämpfungsglied 7 hochohmig, während es für Gleichstrom niederohmig ist, so dass der Gleichstrom praktisch ungehindert zum DC-Motor 1 fließen kann.

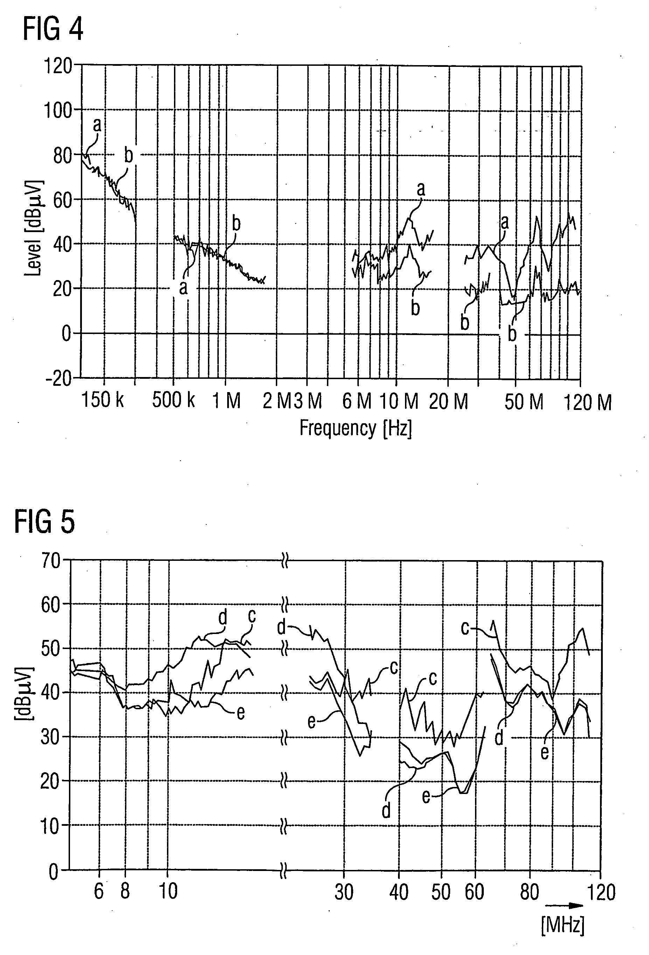

Anaand der Figuren 4 und 5 wird die Wirkungsweise der erfindungsgemäßen Schaltungsanordnung näher erläutert. Figur 4 zeigt ein erstes Diagramm, bei dem auf der x-Achse die Signalfrequenz in Hz und auf der y-Achse die Amplitude (Level in dBµV) aufgetragen sind. Die dargestellten Kurven stellen Einzelfälle dar, die für einen bestimmten DC-Motor 1 ausgelegt sind. Die Segmente der Kurve a (dünne Linie) zeigen an Hand eines Messprotokolls das Bürstenfeuer des DC-Motors 1, wenn keine EMV-Enstörung durchgeführt wird. Hier ist erkennbar, dass insbesondere bei niedrigen Frequenzen die Störstrahlung besonders hoch ist, mit zunehmender Frequenz etwas fällt und im Frequenzbereich 6 bis ca. 120 MHz wieder ansteigt.

Zum Vergleich hierzu zeigen die Segmente der Kurve b (fette Linie) den Fall, wenn der gleiche DC-Motor 1 mit dem erfindungsgemäßen Dämpfungsglied 7 beschaltet ist. Bei dieser beispielhaften Auslegung des Common Mode Ferrit 9 ist im unteren Frequenzbereich bis ca. 2 MHz kein wesentlicher Unterschied zur Kurve a erkennbar. Bei höheren Frequenzen ab ca. 6 MHz ist der Störpegel der Kurve b jedoch deutlich reduziert. Während der Störpegel der Kurve a einen Pegel zwischen ca. 30 bis 50 dBµV aufweist, liegt der Pegel bei der Kurve b nur im Bereich von ca 10 bis 30 dBµV. Ähnliches ist im Frequenzbereich 25 bis 120 MHz erkennbar. Dieses ist eine deutliche Reduzierung des Störpegels gegenüber dem nichtentstörten Fall der Kurve a.

Figur 5 zeigt ein zweites Diagramm mit einer ähnlichen Skalierung, wie sie bereits zu Figur 4 beschrieben wurde. Hier wird jedoch der Frequenzbereich auf der x-Achse im Intervall ab ca. 5 MHz bis ca. 120 MHz betrachtet. Das Diagramm zeigt drei unterschiedliche Messkurven c,d,e. Die Segmente der Kurve c geben den Fall wieder, wenn der DC-Motor 1 ohne Dämpfungsglied 7 beschaltet ist. Die Segmente der Kurve d zeigen den Störpegelverlauf, wenn der DC-Motor 1 mit einem konventionellen L/C-Glied mit L= 7µH und C=10nF beschaltet wurde. Die fett gezeichneten Segmente der Kurve e zeigen den Fall, wenn der DC-Motor 1 mit dem erfindungsgemäßen Common Mode Ferrit 9 beschaltet wurde. Aus den Kurvenabschnitten in den vier dargestellten Frequenzbereichen ist erkennbar, dass der Störpegel bei der Kurve e insgesamt niedriger ist als bei den Kurven c und d. Insbesondere ist ersichtlich, dass im mittleren Frequenzbereich zwischen 25 und 35 MHz der Störpegel der Kurve e deutlich niedriger verläuft als bei der Kurve d, die der Bestückung mit dem konventionellen L/C-Glied entspricht. Dieser Frequenzbereich kann sich natürlich verschieben, wenn das Dämpfungsglied 7 anders dimensioniert wird.

Zu diesen Vorteilen kommt hinzu, dass die Bauweise mit dem Common Mode Ferrit 9 wesentlich kleiner ausgeführt werden kann als mit dem konventionellen L/C-Glied, so dass sich daraus weitere konstruktive Vorteile ergeben, wie bereits erwähnt wurde.

## Patentansprüche

1. Schaltungsanordnung zur EMV-Entstörung eines Gleichstrommotors (1), wobei in die Versorgungsleitung (4) des Gleichstrommotors (1) ein Dämpfungsglied (7) geschaltet ist, das insbesondere für hochfrequente Signale einen hohen Widerstand bildet, wobei das Dämpfungsglied (7) ein Ferritmaterial aufweist, **dadurch gekennzeichnet, dass** das Dämpfungsglied (7) auf einer gedruckten Schaltung (6) angeordnet ist, die für eine nachträgliche Bestückung mit dem Dämpfungsglied (7) ausgebildet ist.

2. Schaltungsanordnung nach Anspruch 1, **dadurch gekennzeichnet, dass** das Dämpfungsglied (7) als Common Mode Ferrit ausgebildet ist.

3. Schaltungsanordnung nach einem der vorhergehenden Ansprüche, **dadurch gekennzeichnet, dass** das Dämpfungsglied (7) möglichst nahe am oder im Gehäuse (5) des Gleichstrommotors (1) angeordnet ist.

4. Schaltungsanordnung nach einem der vorhergehenden Ansprüche, **dadurch gekennzeichnet, dass** das Dämpfungsglied (7) auf einer gedruckten Schaltung (6) angeordnet ist, die zur Ansteuerung des Gleichstrommotors (1) dient.

5. Schaltungsanordnung nach Anspruch 4, **dadurch gekennzeichnet, dass** die gedruckte Schaltung (6) mit dem Dämpfungsglied (7) und dem Gleichstrommotor (1) in einem gemeinsamen Gehäuse angeordnet ist, das als Schaltmodul (10) verwendbar ist.

6. Schaltungsanordnung nach einem der vorhergehenden Ansprüche, **dadurch gekennzeichnet, dass** das Dämpfungsglied (7) als SMD-Schaltung ausgebildet ist.

7. Schaltungsanordnung nach einem der Ansprüche 5 und/ oder 6, **dadurch gekennzeichnet, dass** das Dämpfungsglied (7) ausgebildet ist, die am Kommutator des Gleichstrommotors (1) entstehenden Störsignale des Bürstenfeuers zu dämpfen.

8. Schaltungsanordnung nach einem der vorhergehenden Ansprüche, **dadurch gekennzeichnet, dass** der Gleichstrommotor (1) zum Antrieb eines Hilfsaggregates für ein Kraftfahrzeug ausgebildet ist.

9. Schaltungsanordnung nach Anspruch 8, **dadurch gekennzeichnet, dass** der Gleichstrommotors (1) für eine Getriebesteuerung, einen Scheibenwischer, einen Fensterheber, eine Sitzverstellung oder dergleichen verwendbar ist.

10. Schaltmodul mit einem Gleichstrommotor(1), mit einer Steuerschaltung auf einer gedruckten Schaltung (6) und mit einem Dämpfungsglied (7) nach einem der vorhergehenden Ansprüche, **dadurch gekennzeichnet, dass** das Dämpfungsglied (7) einen Common Mode Ferrit (9) aufweist und auf der gedruckten Schaltung (6) möglichst nahe am oder im Gleichstrommotor (1) angeordnet ist und dass das Dämpfungsglied (7), die gedruckte Schaltung (6) und der Gleichstrommotor (1) in einem gemeinsamen Gehäuse (10) eingebaut sind.

## Claims

1. Circuit arrangement for EMC interference suppression for a direct current motor (1) with an attenuation element (7) being connected in the supply line (4) of the direct current motor (1), forming a high resistance for high-frequency signals in particular, with the attenuation element (7) comprising a ferrite material, **characterised in that** the attenuation element (7) is disposed on a printed circuit (6), which is configured for later insertion of the attenuation element (7).

2. Circuit arrangement according to claim 1,
**characterised in that** the attenuation element (7) is configured as a common mode ferrite.

3. Circuit arrangement according to one of the preceding claims, **characterised in that** the attenuation element (7) is disposed as close as possible to or in the housing (5) of the direct current motor (1).

4. Circuit arrangement according to one of the preceding claims, **characterised in that** the attenuation element (7) is disposed on a printed circuit (6) which serves to control the direct current motor (1).

5. Circuit arrangement according to claim 4, **characterised in that** the printed circuit (6) with the attenuation element (7) and the direct current motor (1) is arranged in a common housing, which can be used as a switching module (10).

6. Circuit arrangement according to one of the preceding claims, **characterised in that** the attenuation element (7) is configured as an SMD circuit.

7. Circuit arrangement according to one of claims 5 and/or 6,
**characterised in that** the attenuation element (7) is configured to attenuate the interference signals due to sparking resulting at the commutator of the direct current motor (1).

8. Circuit arrangement according to one of the preceding claims, **characterised in that** the direct current motor (1) is configured to drive an auxiliary generating set for a motor vehicle.

9. Circuit arrangement according to claim 8, **characterised in that** the direct current motor (1) can be used for a transmission control, windshield wipers, a window closing system, a seat adjuster, etc.

10. Switching module with a direct current motor (1) with a control circuit on a printed circuit (6) and with an attenuation element (7) according to one of the preceding claims, **characterised in that** the attenuation element (7) comprises a common mode ferrite (9) and is disposed on the printed circuit (6) as close as possible to or in the direct current motor (1) and that the attenuation element (7), the printed circuit (6) and the direct current motor (1) are integrated in a shared housing (10).

## Revendications

1. Circuit de déparasitage aux fins de compatibilité électromagnétique d'un moteur à courant continu (1), un atténuateur (7) étant monté dans la ligne d'alimentation (4) du moteur à courant continu (1), ledit atténuateur (7) formant une résistance élevée en particulier pour des signaux haute fréquence et comportant un matériau à base de ferrite, **caractérisé en ce que** l'atténuateur (7) est monté sur un circuit imprimé (6), qui est réalisé pour être équipé ultérieurement avec l'atténuateur (7).

2. Circuit selon la revendication 1, **caractérisé en ce que** l'atténuateur (7) est réalisé sous la forme d'une ferrite de mode commun.

3. Circuit selon l'une quelconque des revendications précédentes, **caractérisé en ce que** l'atténuateur (7) est agencé aussi près que possible sur le boîtier (5) ou dans le boîtier (5) du moteur à courant continu (1).

4. Circuit selon l'une quelconque des revendications précédentes, **caractérisé en ce que** l'atténuateur (7) est agencé sur un circuit imprimé (6), qui est utilisé pour commander le moteur à courant continu (1).

5. Circuit selon la revendication 4, **caractérisé en ce que** le circuit imprimé (6) avec l'atténuateur (7) et le moteur à courant continu (1) est monté dans un boîtier commun, qui peut être utilisé comme module de commutation (10).

6. Circuit selon l'une quelconque des revendications précédentes, **caractérisé en ce que** l'atténuateur (7) est réalisé sous la forme d'un circuit à composants montés en surface (circuit CMS).

7. Circuit selon l'une des revendications 5 et/ou 6, **caractérisé en ce que** l'atténuateur (7) est réalisé pour produire une atténuation des signaux parasites, provenant des étincelles aux balais et générés au niveau du commutateur du moteur à courant continu (1).

8. Circuit selon l'une quelconque des revendications précédentes, **caractérisé en ce que** le moteur à courant continu (1) est réalisé pour l'entraînement d'un organe auxiliaire pour un véhicule automobile.

9. Circuit selon la revendication 8, **caractérisé en ce que** le moteur à courant continu (1) peut être utilisé pour une commande de boîte de vitesses, un essuie-glace, un lève-vitre, un réglage de siège ou tout élément similaire.

10. Module de commutation avec un moteur à courant continu (1), avec un circuit de commande sur un circuit imprimé (6) et avec un atténuateur (7) selon l'une quelconque des revendications précédentes, **caractérisé en ce que** l'atténuateur (7) comporte une ferrite de mode commun (9) et est agencé sur le circuit imprimé (6) aussi près que possible du ou dans le moteur à courant continu (1), et **en ce que** l'atténuateur (7), le circuit imprimé (6) et le moteur à courant continu (1) sont montés dans un boîtier (10) commun.
